(19) Europäisches Patentamt
European Patent Office
Office européen des brevets

(11) **EP 2 131 397 B1**

(12) **FASCICULE DE BREVET EUROPEEN**

(45) Date de publication et mention
de la délivrance du brevet:
**07.12.2011 Bulletin 2011/49**

(51) Int Cl.:
***H01L 27/11*** (2006.01)     ***H01L 21/8244*** (2006.01)
***H01L 27/06*** (2006.01)

(21) Numéro de dépôt: **09161129.3**

(22) Date de dépôt: **26.05.2009**

(54) **Circuit à transistors intégrés en trois dimensions et ayant une tension de seuil vt ajustable dynamiquement**

In drei Dimensionen integrierter Transistorschaltkreis mit einer dynamisch anpassbaren Schwellenspannung (VT)

Circuit with transistors integrated in three dimensions with a dynamically adjustable voltage threshold vt

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **02.06.2008 FR 0853607**

(43) Date de publication de la demande:
**09.12.2009 Bulletin 2009/50**

(73) Titulaire: **Commissariat à l'Énergie Atomique et aux Énergies Alternatives**
**75015 Paris (FR)**

(72) Inventeurs:
• **Batude, Perrine**
**38000 GRENOBLE (FR)**
• **Clavelier, Laurent**
**38000 GRENOBLE (FR)**
• **Jaud, Marie-Anne**
**38000, GRENOBLE (FR)**
• **Thomas, Olivier**
**38420 REVEL (FR)**
• **Vinet, Maud**
**38140 RIVES (FR)**

(74) Mandataire: **Ilgart, Jean-Christophe**
**BREVALEX**
**95 rue d'Amsterdam**
**75378 Paris Cedex 8 (FR)**

(56) Documents cités:
**EP-A- 1 705 693        US-A- 5 548 153**
**US-A- 5 567 959        US-A1- 2006 062 061**
**US-A1- 2007 181 880**

## Description

## DOMAINE TECHNIQUE

La présente invention se rapporte au domaine de la microélectronique et en particulier à celui des dispositifs comportant des transistors répartis sur plusieurs niveaux.

Elle concerne la réalisation d'un dispositif microélectronique doté de transistors intégrés sur 3 dimensions et de moyens pour moduler la tension de seuil de transistors par couplage à l'aide de la grille de transistors de niveaux inférieurs.

Elle apporte des améliorations notamment en termes d'encombrement, de performances électriques, de vitesse de fonctionnement, et permet de modifier de manière dynamique la tension de seuil de certains des transistors du dispositif, et de diminuer des effets de canaux courts de ces transistors.

L'invention s'applique notamment au domaine des mémoires à accès aléatoires, telles que les mémoires SRAM (SRAM pour « static random access memory » ou mémoires statiques à accès aléatoires).

## ÉTAT DE LA TECHNIQUE ANTÉRIEURE

De manière générale, on cherche continuellement à augmenter la densité des composants dans les dispositifs microélectroniques.

Pour ce faire, parmi un nombre important de solutions possibles, des dispositifs dans lesquels les transistors sont intégrés sur 3 dimensions et répartis sur plusieurs niveaux sont conçus.

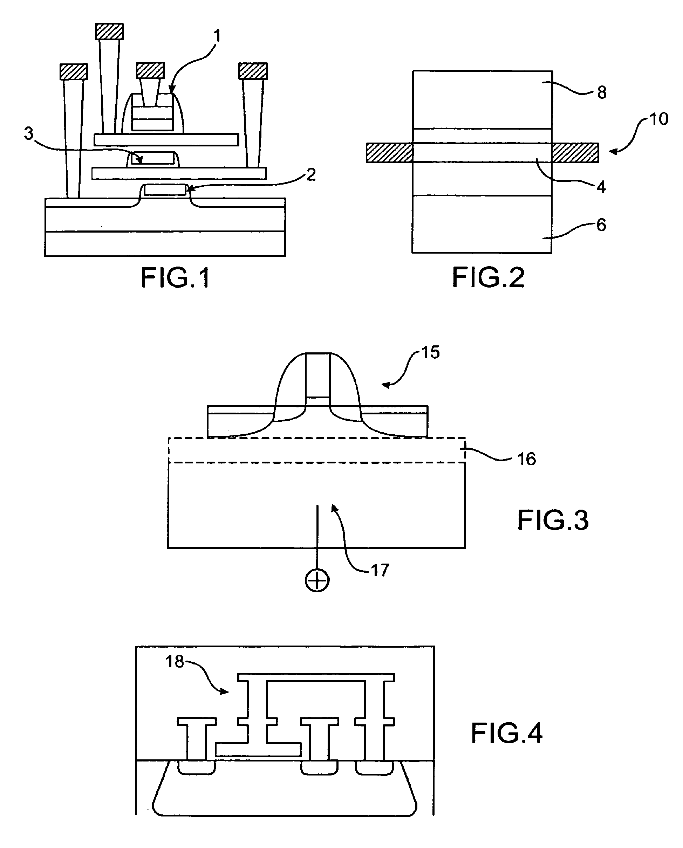

Le document EP 1 705 693 divulgue par exemple un dispositif dans lequel on intercale une capacité 3 entre deux transistors 1 et 2 répartis sur deux niveaux différents superposés. Les électrodes de la capacité 3 sont mises à un potentiel fixe, ce qui permet de découpler les deux transistors. En plus de permettre d'obtenir une densité d'intégration améliorée, un tel agencement permet de limiter le bruit généré entre les différents niveaux de transistors (figure 1).

On cherche également continuellement à diminuer la consommation des dispositifs microélectroniques.

Pour cela, une solution classique consiste à réduire leur tension d'alimentation. Cependant une réduction de la tension d'alimentation en dessous d'une valeur de l'ordre de 3 fois la tension de seuil des transistors, est susceptible de dégrader de manière significative la vitesse de fonctionnement de ces derniers. Pour diminuer la tension d'alimentation, on peut ainsi avoir à diminuer la tension de seuil des transistors. Mais une diminution de la tension de seuil a tendance à entrainer une augmentation de la consommation statique.

Pour résoudre ce problème, des dispositifs dans lesquels on modifie de manière dynamique la tension de seuil de certains transistors sont notamment apparus.

Une modification dynamique de la tension de seuil a été réalisée sur des architectures de transistors MOS à double-grille (également appelé DGMOS pour « Double Gate MOSFET »), de transistor MOS sur substrat SOI (SOI pour « Silicon on Insulator ») avec contrôle de la tension de face arrière, ou de transistor DTMOS (DTMOS pour « Dynamic Threshold Voltage MOSFET »).

Un transistor 10 double-grille peut être mis en oeuvre avec une tension de seuil ajustable. Un tel mode de fonctionnement repose sur un couplage entre une zone du canal 4 et la grille avant 8 du transistor, et un couplage entre une autre zone du canal 4 et la grille arrière 6 du transistor. Dans ce cas, la grille arrière 6 du transistor est utilisée comme grille de contrôle. Suivant la manière dont est polarisée cette grille arrière, on peut induire une modification de la tension de seuil du transistor (figure 2).

Pour modifier la tension de seuil d'un transistor, une structure dite « à plan de masse » a également été proposée.

Une telle structure fait appel à la technologie SOI (SOI pour « silicon on insulator » ou « silicium sur isolant »), et comporte une zone dopée 17 située sous un emplacement prévu pour un transistor 15 et sous un couche isolante 16 d'un substrat SOI. Une polarisation adéquate de cette zone dopée permet de modifier la tension de seuil du transistor par couplage électrostatique à travers la couche isolante du substrat SOI (figure 3).

Un exemple de structure à plan de masse est donnée dans le document US 7 115 950.

Une structure de transistor à plan de masse, dotée d'un oxyde enterré d'épaisseur très fine, a quant à elle été décrite dans le document de Tetsu Ohtou : « Variable-Body-Factor SOI MOSFET With Ultrathin Buried Oxide for Adaptive Threshold Voltage and Leakage Control », IEEE Transactions on Electron Devices, volume 55, n° 1, janvier 2008. Une telle structure présente une capacité importante entre les zones de source et de drain et le substrat, ce qui a tendance à induire une dégradation des délais de propagation des signaux.

Pour répondre à cette problématique, il a été proposé de moduler le coefficient de couplage en modifiant l'état de l'interface entre le substrat et l'oxyde enterré de l'inversion à la déplétion et vice et versa en mettant en oeuvre une polarisation de la face arrière du substrat. Dans ce cas, une vitesse de fonctionnement élevée ainsi qu'une faible capacité peuvent être obtenues dans le mode passant, tout en garantissant une puissance consommée faible à l'état bloqué grâce à un coefficient de couplage élevé à l'état bloqué.

Une structure de transistor 18 particulière appelée DTMOS (DTMOS pour « Dynamic Threshold Voltage MOSFET ») présente une connexion reliant sa grille 20 à son body 22 comme cela est représenté sur la figure 4.

Une modification de tension de seuil du transistor 18 peut être obtenue dans ce cas, en modifiant la polarisation de la grille 20. La connexion grille 20-body 22 permet d'abaisser la tension de seuil $V_T$ du transistor 18 à l'état passant, la tension de seuil reprenant sa valeur d'origine, plus élevée, à l'état bloqué. Le fonctionnement du transistor DTMOS est limité à une tension d'alimentation faible, par exemple inférieure à 0.7V du fait de la création d'un bipolaire parasite pour des tensions d'alimentation élevées.

Le document US 5 567 959 présente un dispositif microélectronique à transistors TFT superposés dans lequel la grille d'un premier transistor TFT est couplée électriquement au canal d'un deuxième transistor TFT reposant sur ce premier transistor et séparé de ce dernier par l'intermédiaire d'une couche de matériau diélectrique. L'agencement du dispositif est tel qu'il pose des problèmes de planéité et qu'un couplage électrique parasite peut s'établir entre les zones d'accès du premier transistor et du deuxième transistor, ce qui a tendance à réduire la vitesse de fonctionnement du dispositif.

Le document US 2006/0062061 présente une mémoire SRAM comprenant des transistors TFT superposés.

Il se pose le problème de trouver un nouveau dispositif microélectronique à transistors superposés, qui réponde à la fois aux critères de densité d'intégration réduite et de faible consommation, et présente des améliorations en termes de performances électriques.

## EXPOSÉ DE L'INVENTION

L'invention concerne tout d'abord un dispositif microélectronique à transistors superposés selon la revendication 1.

La première région de la zone isolante est prévue de manière à permettre un couplage entre l'électrode de grille du premier transistor et le canal du deuxième transistor.

Entre les zones d'accès respectives du premier transistor et du deuxième transistor, la deuxième région de la zone isolante peut être prévue, de par sa composition et son épaisseur, de manière à limiter un couplage entre au moins une zone d'accès, c'est-à-dire une zone de source ou de drain, et au moins une zone d'accès (source ou drain) du deuxième transistor.

Par zone d'accès on entend une zone de source ou de drain d'un transistor.

L'invention concerne également un dispositif microélectronique comprenant :

- un substrat surmonté d'un empilement de couches,
- au moins un premier transistor situé à un niveau donné dudit empilement,
- au moins un deuxième transistor situé à un deuxième niveau dudit empilement, au dessus dudit niveau donné, le premier transistor comportant une électrode de grille située en regard d'une zone de canal du deuxième transistor, le premier transistor et le deuxième transistor étant séparés par l'intermédiaire d'une zone isolante,

ladite zone isolante étant constituée de plusieurs matériaux diélectriques différents, et ayant dans une première région entre ladite grille dudit premier transistor et ledit canal dudit deuxième transistor, une composition et une épaisseur prévues de manière à former une première capacité électrique C1 entre l'électrode de grille du premier transistor et le canal du deuxième transistor, ladite zone isolante comportant une deuxième région entre au moins une zone d'accès du premier transistor et au moins une zone d'accès du deuxième transistor, de composition et d'épaisseur prévues de manière à former une deuxième capacité électrique C2 entre ladite zone d'accès du premier transistor et ladite zone d'accès du deuxième transistor, telle que C2 < C1.

La zone isolante peut former dans la première région, une première capacité C1 permettant un couplage entre la grille du premier transistor et le canal du deuxième transistor.

La zone isolante peut former dans la deuxième région entre ladite zone d'accès dudit premier transistor et ladite zone d'accès dudit deuxième transistor, une capacité C2 limitant le couplage entre ladite zone d'accès du premier transistor et ladite zone d'accès du deuxième transistor.

Ainsi, on peut moduler la tension de seuil du deuxième transistor par couplage avec le premier transistor en prévoyant une première région de la zone isolante de propriétés diélectriques et d'épaisseur données, tout en limitant ou en empêchant un couplage intempestif entre les zones d'accès respectives du premier et du deuxième transistor, en prévoyant une deuxième région de la zone isolante, de propriétés diélectriques et d'épaisseur différentes de celles de la première région.

Du fait du couplage entre la grille du premier transistor et la zone de canal du deuxième transistor, le deuxième transistor peut avoir une tension de seuil dépendante de la polarisation de la grille du premier transistor.

Le dispositif comprend également des moyens de polarisation pour appliquer un potentiel à la grille du premier transistor, en particulier un potentiel variable.

Ainsi, le dispositif suivant l'invention peut comprendre des moyens pour moduler la tension de seuil du deuxième transistor, lesdits moyens comprenant des moyens de polarisation pour appliquer un potentiel à la grille du premier transistor, en particulier un potentiel variable.

Une modification dynamique de la tension de seuil $V_T$ du deuxième transistor peut par exemple consister,

- à imposer au deuxième transistor, à l'aide d'un potentiel appliqué au premier transistor, une première tension de seuil $V_{T1}$,

- à imposer au deuxième transistor, à l'aide d'un autre potentiel appliqué au premier transistor, une tension de seuil $V_{T2}$, supérieure à la première tension de seuil $V_{T1}$.

La première tension de seuil est de préférence une tension de seuil faible, tandis que la deuxième tension de seuil est de préférence une tension de seuil élevée.

Ainsi, afin de faire varier la tension de seuil du deuxième transistor, lesdits moyens de polarisation peuvent être mis en oeuvre pour :

- pendant au moins une première phase, appliquer à la grille du premier transistor, au moins un premier potentiel, ledit deuxième transistor ayant alors une première tension de seuil $V_{T1}$,
- pendant au moins une deuxième phase, appliquer à la grille du premier transistor, au moins un deuxième potentiel différent dudit premier potentiel, ledit deuxième transistor ayant alors une deuxième tension de seuil $V_{T2}$ différente de la première tension de seuil $V_{T1}$.

Selon une possibilité, le premier potentiel peut être un potentiel prévu pour rendre passant le premier transistor, le deuxième potentiel étant prévu pour rendre bloqué le premier transistor.

Le dispositif microélectronique suivant l'invention peut ainsi comprendre des moyens pour moduler la tension de seuil du deuxième transistor en faisant varier le potentiel de grille du premier transistor.

La zone isolante a, dans la première région, une épaisseur $e_c$ suffisamment faible pour permettre un couplage entre l'électrode de grille du premier transistor et le canal du deuxième transistor.

La zone isolante peut avoir, dans la première région, une épaisseur équivalente EOT en oxyde de silicium inférieure à 20 nanomètres.

La zone isolante est en particulier prévue pour permettre un couplage tel, qu'une variation du potentiel de grille du premier transistor, entraine une variation de la tension de seuil du deuxième transistor.

Le couplage peut être tel, qu'une variation du potentiel de grille du premier transistor d'au plus Vdd (avec Vdd une tension d'alimentation du dispositif) permette d'obtenir une variation de tension de seuil du deuxième transistor d'au moins 50 mV.

L'épaisseur ainsi que les matériaux diélectriques de la zone isolante sont choisis pour permettre un couplage entre l'électrode de grille du premier transistor et le canal du deuxième transistor.

L'épaisseur ainsi que les matériaux diélectriques de la zone isolante peuvent être également choisis pour permettre d'empêcher un couplage entre les zones d'accès du premier transistor et celles du deuxième transistor.

La zone isolante peut ainsi avoir, dans la deuxième région, entre les zones d'accès du premier transistor et celles du deuxième transistor, une épaisseur équivalente EOT en oxyde de silicium supérieure à 60 nanomètres.

Le deuxième transistor peut être formé sur une couche semi-conductrice totalement désertée.

Selon une possibilité de mise en oeuvre du dispositif microélectronique, entre ladite grille et ladite zone de canal, ladite zone isolante peut être formée d'une première région à base d'un premier matériau diélectrique ayant une première constante diélectrique $k_1$, tandis qu'en regard des zones de source et de drain dudit premier transistor, ladite zone isolante est formée d'une deuxième région à base d'un deuxième matériau diélectrique ayant une deuxième constante diélectrique $k_2$ telle que $k_2 < k_1$.

Selon une autre possibilité de mise en oeuvre du dispositif microélectronique, entre ladite grille et ladite zone de canal, ladite zone isolante peut être formée d'une première région à base d'un premier matériau diélectrique ayant une première constante diélectrique $k_1$, tandis qu'en regard des zones de source et de drain dudit premier transistor, ladite zone isolante est formée d'une deuxième région à base d'un empilement dudit premier matériau diélectrique et dudit deuxième matériau diélectrique.

Selon une autre possibilité de mise en oeuvre du dispositif microélectronique, ladite première région peut être formée d'un premier empilement d'un premier matériau diélectrique et d'un deuxième matériau diélectrique, ladite d'une deuxième région comportant un deuxième empilement dudit premier matériau diélectrique et du deuxième matériau diélectrique, les épaisseurs respectives du premier matériau diélectrique et du deuxième matériau diélectrique étant différentes dans le premier empilement et dans le deuxième empilement.

Le premier diélectrique peut être par exemple un diélectrique communément appelé « high-k » tel que du $HfO_2$.

Le deuxième diélectrique peut être par exemple du $SiO_2$.

On peut ainsi avoir un dispositif dans lequel un couplage entre la grille du premier transistor et le canal du deuxième transistor est mis en oeuvre, tandis que les autres zones du deuxième transistor sont totalement découplées du premier transistor.

Selon une possibilité, les moyens de polarisation peuvent être prévus pour appliquer un potentiel variable, entre 0 et Vdd ou entre -Vdd et +Vdd, avec Vdd un potentiel d'alimentation du dispositif.

Le dispositif microélectronique peut comprendre plus de deux transistors superposés.

Ainsi, le dispositif microélectronique peut comprendre en outre, dans un axe orthogonal au plan principal du substrat et passant par la grille du premier transistor et/ou du deuxième transistor, un ou plusieurs autres transistors.

Selon une possibilité, le dispositif microélectronique peut comprendre en outre : un ou plusieurs autres transistors dans un plan parallèle au plan principal du substrat et passant par la grille du premier transistor et/ou la grille du deuxième transistor.

Selon une possibilité de mise en oeuvre, le dispositif microélectronique peut comprendre en outre : au moins un plot de contact entre la grille du premier transistor et la grille du deuxième transistor.

Le dispositif peut comprendre en outre : au moins un troisième transistor situé au niveau dudit premier transistor dans ledit empilement, et au moins un quatrième transistor, un cinquième transistor de découplage étant situé entre le troisième transistor et le quatrième transistor.

Selon une variante, le dispositif peut comprendre en outre : au moins un troisième transistor situé au niveau dudit premier transistor dans ledit empilement, au moins un quatrième transistor situé au dessus du troisième transistor, le quatrième transistor et le troisième transistor étant séparés par l'intermédiaire d'une zone diélectrique prévue pour limiter un couplage entre le troisième transistor et le quatrième transistor.

Selon une possibilité de mise en oeuvre, le dispositif peut comprendre au moins un transistor doté d'un canal formé dans une zone semi-conductrice entourée par des zones isolantes d'épaisseur égale ou sensiblement égale à l'épaisseur de la zone semi-conductrice, le diélectrique de grille et la grille du premier transistor, reposant sur lesdites zones isolantes et sur la zone semi-conductrice.

Un tel agencement peut permettre de réduire la topographie de la grille et permettre d'atténuer l'impact d'un désalignement involontaire entre la grille supérieure et inférieure.

Le dispositif microélectronique peut être une cellule mémoire, en particulier une cellule de mémoire SRAM.

L'invention concerne également un procédé de réalisation d'un dispositif microélectronique tel que défini plus haut.

L'invention concerne en particulier un procédé de réalisation d'un dispositif microélectronique comprenant les étapes de :

a) formation sur un substrat d'au moins un premier transistor doté d'une région de source, d'une région de drain, d'une structure formant un canal reliant la région de source et la région de drain, et d'une grille sur le canal,

b) formation sur le premier transistor d'une zone isolante ayant, dans une première région située sur ladite grille une composition et une épaisseur données, et dans une deuxième région située sur au moins une zone d'accès du premier transistor une composition et une épaisseur différentes de celles de ladite première région,

c) formation sur la zone isolante d'une couche semi-conductrice au dessus du premier transistor et d'un deuxième transistor à partir de ladite couche semi-conductrice.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1, illustre un exemple de dispositif microélectronique suivant l'art antérieur, doté de transistors répartis sur 2 niveaux superposés ;
- la figure 2 illustre un exemple de transistor à double-grille,
- la figure 3 illustre exemple de structure de transistor sur SOI à plan de masse,
- la figure 4 illustre exemple de structure de transistor de type DTMOS,
- la figure 5 illustre un exemple de dispositif microélectronique à 2 transistors superposés, et séparés par une zone isolante prévue de sorte que le canal du transistor de niveau supérieur est couplé électro statiquement avec la grille du transistor de niveau inférieur,
- la figure 6 illustre un exemple de dispositif microélectronique, à n transistors superposés, dont n-1 transistors ont un canal couplé électro statiquement avec la grille d'un transistor de niveau inférieur,
- la figure 7 illustre un exemple de dispositif microélectronique à 2 transistors superposés dont les grilles ont des axes de symétries distincts, le canal du transistor de niveau supérieur étant couplé avec la grille du transistor de niveau inférieur,
- la figure 8 illustre l'évolution, dans un exemple de dispositif microélectronique de type pMOS , de la tension de seuil d'un transistor d'un niveau N donné en fonction du potentiel de grille d'un transistor de niveau N-1 inférieur audit niveau donné, en comparaison avec l'évolution de la tension de seuil d'un transistor dans un dispositif microélectronique comportant également des transistors superposés, mais davantage espacés les uns des autres,
- la figure 9 illustre l'évolution, dans un exemple de dispositif microélectronique de type pMOS du courant Ioff à l'état bloqué d'un transistor d'un niveau N donné en fonction du potentiel de grille d'un transistor de niveau N-1 inférieur audit niveau donné, ainsi que l'évolution, dans des dispositifs microélectroniques comportant également des transistors superposés, mais davantage espacés les uns des autres,
- la figure 10 illustre l'évolution, dans un exemple de dispositif microélectronique de type pMOS , du courant Ion à l'état passant d'un transistor d'un niveau N donné en fonction du potentiel de grille d'un transistor de niveau N-1 inférieur audit niveau donné, ainsi que l'évolution, du courant Ion à l'état passant d'un transistor d'un niveau N donné en fonction du potentiel de grille d'un transistor de niveau N-1 inférieur audit niveau donné, dans des dispositifs microélectroniques comportant également des transistors superposés, mais davantage espacés les uns des autres,

- la figure 11 illustre l'évolution, dans un dispositif microélectronique, de la tension de seuil d'un transistor de type n d'un niveau N donné en fonction du potentiel de grille d'un transistor de type p de niveau N-1 inférieur audit niveau donné, en comparaison avec l'évolution, dans un dispositif microélectronique suivant l'invention, de la tension de seuil d'un transistor de type p d'un niveau N donné en fonction du potentiel de grille d'un transistor de type n de niveau N-1 inférieur audit niveau donné,

- les figures 12A-12B illustrent un exemple de dispositif microélectronique, doté de moyens de polarisation de grille de transistor, prévus pour appliquer un potentiel variable,

- la figure 13 illustre un exemple de dispositif microélectronique, comportant, sur un même substrat, des transistors superposés et couplés entre eux, avec des transistors superposés, qui ne sont pas couplés et séparés par un niveau laissé vide ;

- la figure 14 illustre un exemple de dispositif microélectronique comportant deux transistors superposés avec une zone de contact entre les grilles des deux transistors,

- les figures 15A-15C et 16 illustrent un exemple de procédé de réalisation d'un dispositif microélectronique,

- la figure 17 illustre un exemple de dispositif microélectronique suivant l'invention, à 2 transistors superposés et séparés par une zone isolante comportant plusieurs matériaux diélectriques de constantes diélectriques différentes, d'agencement et d'épaisseurs prévues de sorte que le canal du transistor de niveau supérieur est couplé électriquement avec la grille du transistor de niveau inférieur, les autres régions du transistor de niveau supérieur n'étant pas couplées au transistor de niveau inférieur,

- la figure 18 illustre une variante de l'exemple de dispositif microélectronique de la figure 14,

- les figures 19A-19B illustrent un exemple de procédé de réalisation d'un dispositif microélectronique suivant l'invention,

- les figures 20A-20C illustrent un exemple de procédé de réalisation d'un dispositif microélectronique suivant l'invention,

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

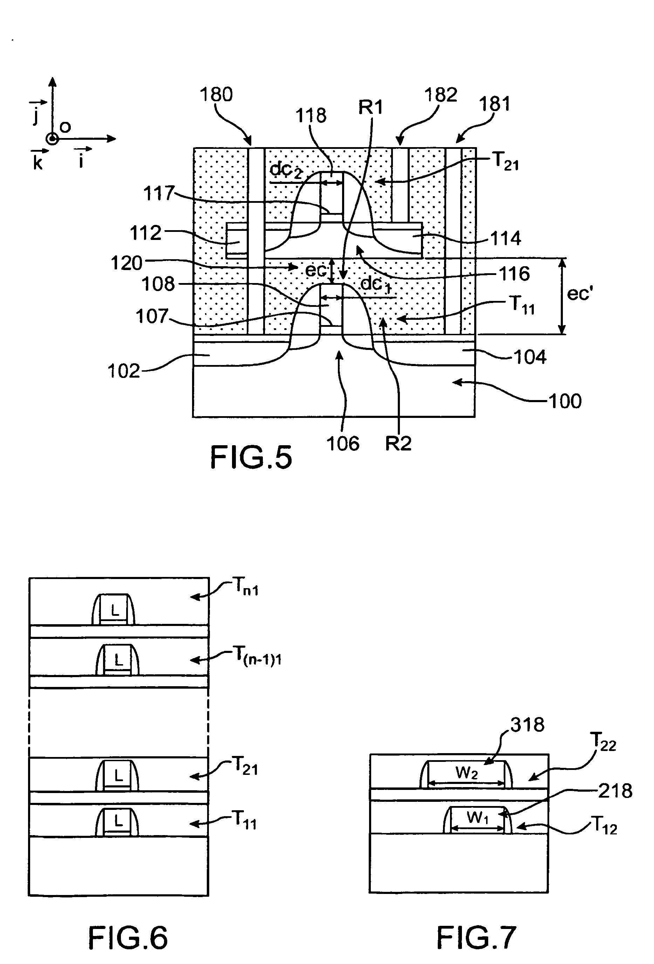

Un exemple de dispositif microélectronique à transistors superposés va être donné en liaison avec la figure 5.

Ce dispositif comprend tout d'abord un substrat 100, qui peut être un substrat massif (« bulk » suivant la terminologie anglo-saxonne) ou de type semi-conducteur sur isolant, par exemple de type SOI (SOI pour « silicon on insulator » ou « silicium sur isolant »), comportant une première couche de support qui peut être semi-conductrice et par exemple à base de Si, recouverte par une couche isolante, par exemple à base de $SiO_2$, elle-même recouverte par une couche semi-conductrice, par exemple à base de Si, et dans laquelle une ou plusieurs zones actives sont susceptibles d'être formée(s).

Sur le substrat 100, repose un empilement de couches dans lequel figure un premier transistor $T_{11}$ comportant des zones d'accès, c'est à dire une région de source 102 et une région de drain 104, et ainsi qu'une zone 106 de canal entre les zones d'accès 102, 104. Le premier transistor $T_{11}$ peut être éventuellement formé sur un substrat SOI totalement déserté ou partiellement déserté.

Le premier transistor $T_{11}$ comporte également une électrode de grille 108 située sur une couche de matériau diélectrique 107 de grille.

Le matériau diélectrique 107 peut avoir une épaisseur équivalente en $SiO_2$, également appelée épaisseur EOT (EOT pour « Equivalent Oxide Thickness ») par exemple comprise entre 0.5 et 5 nm. Le matériau diélectrique 107 peut être par exemple du $SiO_2$ ou un matériau de type communément appelé « high-k » tel que du $HfO_2$.

La grille 108 du premier transistor $T_{11}$, peut avoir une dimension critique $dc_1$ comprise par exemple entre 10 et 1000 nanomètres (la dimension critique $dc_1$ étant mesurée dans une direction parallèle à celle du vecteur $\vec{i}$ d'un repère orthogonal $[0; \vec{i}; \vec{j}; \vec{k}]$ donné sur la figure 5). Tout au long de la présente description, on entend par « dimension critique », la plus petite dimension d'un motif hormis son épaisseur.

La grille du premier transistor $T_{11}$ peut également avoir une épaisseur comprise par exemple entre 10 et 100 nanomètres (l'épaisseur de la grille étant mesurée dans une direction parallèle à celle du vecteur $\vec{j}$ d'un repère orthogonal $[0; \vec{i}; \vec{j}; \vec{k}]$ donné sur la figure 5).

La grille 108 du premier transistor $T_{11}$ peut être par exemple à base d'un matériau semi-conducteur dopé tel que du polysilicium, ou d'un métal par exemple tel que du TiN.

Le dispositif comporte également au moins un deuxième transistor $T_{21}$ formé au dessus du premier transistor $T_{11}$, dans un niveau de l'empilement supérieur à celui du niveau dans lequel se trouve le premier transistor $T_{11}$.

Le deuxième transistor $T_{21}$ comporte des zones d'accès c'est-à-dire une région de source 112 et une région de drain 114, ainsi qu'une structure de canal 116 entre les zones d'accès, qui relie la région de source 112 et la région de drain 114. Le deuxième transistor $T_{21}$

comporte également une grille 118 reposant sur une couche de diélectrique 117 de grille.

Le diélectrique 117 de grille peut avoir une épaisseur équivalente en $SiO_2$, également appelée épaisseur EOT (EOT pour « Equivalent Oxide Thickness ») comprise par exemple entre 0,5 et 5 nanomètres. Le diélectrique de grille peut être par exemple du $SiO_2$ ou un matériau de type communément appelé « high-k » tel que du Hf02.

La grille 118 du deuxième transistor $T_{21}$ peut avoir une dimension critique $dc_2$ comprise par exemple entre 10 et 100 nanomètres ($dc_2$ étant mesurée dans une direction parallèle à celle du vecteur $\vec{i}$ du repère orthogonal $[0; \vec{i}; \vec{j}; \vec{k}]$). La grille du deuxième transistor $T_{21}$ peut également avoir une épaisseur comprise entre 10 nanomètres et 1000 nanomètres. La grille du deuxième transistor $T_{21}$ peut être par exemple à base d'un matériau semi-conducteur tel que du polysilicium ou d'un métal par exemple tel que du TiN.

Le premier transistor $T_{11}$ et le deuxième transistor $T_{21}$, sont superposés et séparés par une zone isolante 120 nommée ILD (ILD pour « Inter Layer Dielectric ») selon la terminologie anglo-saxonne ou diélectrique inter-niveaux).

Les zones d'accès et de canal du premier transistor $T_{11}$ sont formées dans une couche semi-conductrice parallèle ou sensiblement parallèle à la couche semi-conductrice dans laquelle les zones d'accès et de canal du deuxième transistor $T_{11}$ sont formées.

L'épaisseur de la zone isolante 120 séparant les deux transistors est variable, et diffère entre une première région R1 de la zone isolante 120 située entre la grille du premier transistor $T_{11}$ et la zone de canal du deuxième transistor, et une autre région R2 située à proximité de la première région R1 entre les zones d'accès des deux transistors $T_{11}$ et $T_{21}$.

La grille 108 du premier transistor $T_{11}$ et la zone de canal du deuxième transistor $T_{21}$ sont espacés d'une distance ou d'une épaisseur $e_c$, choisie ou prédéterminée. La grille 108 du premier transistor $T_{11}$ et la zone de canal du deuxième transistor $T_{21}$ sont ainsi séparées par une première région de la zone isolante 120 de faible épaisseur $e_c$.

Entre les zones d'accès du premier transistor $T_{11}$ et celles du deuxième transistor $T_{21}$, la zone isolante 120 a une épaisseur $e'_c$ telle que $e'_c > e_c$.

La zone isolante 120 peut être par exemple à base de $SiO_2$ ou d'un matériau diélectrique communément appelé « high-k » tel que du $HfO_2$.

La zone isolante 120, et en particulier la première région R1 est prévue en termes de composition et d'épaisseur de sorte qu'un couplage électrique peut être établi entre la grille 108 du premier transistor $T_{11}$ et le canal du deuxième transistor $T_{21}$, situé au dessus et en regard de la grille 108 du premier transistor $T_{11}$.

De préférence, l'épaisseur $e_c$ de la première région R1 de cette zone isolante 120 est en particulier choisie bien inférieure à celle des épaisseurs des couches de matériaux diélectrique inter-niveaux dans les dispositifs suivant l'art antérieur, et qui dans ces dispositifs, est prévue pour permettre d'isoler entre eux différents niveaux superposés de composants ou de lignes d'interconnexions.

Par épaisseur $e_c$ ou distance $e_c$ « faible », on entend que $e_c$ peut être comprise entre 1 et 50 nanomètres d'épaisseur équivalente en $SiO_2$, pour permettre le couplage.

En plus de l'épaisseur, la nature du matériau diélectrique de la zone isolante, par exemple du $SiO_2$ ou du $HfO_2$, est également choisie pour permettre d'obtenir un couplage entre la grille du transistor de niveau inférieur et la zone de canal du transistor de niveau supérieur.

L'épaisseur équivalente EOT en $SiO_2$, d'un diélectrique « high-k » d'épaisseur $T_{high-k}$ est obtenue par la relation suivante :

$$ EOT = \frac{\varepsilon_{SiO2}}{\varepsilon_{high-k}} \cdot T_{high-k} $$

Par exemple, une couche de $HfO_2$ ayant une constante diélectrique $k=20$ et une épaisseur de 200 nm, a une épaisseur équivalente EOT en $SiO_2$ de 50 nm.

Avec un tel dispositif, en fonction de la manière dont la polarisation de la grille 108 du premier transistor $T_{11}$ est prévue, la tension de seuil $V_T$ du canal du deuxième transistor $T_{21}$ peut être ajustée. A l'aide d'un tel dispositif, pour faire varier la tension de seuil $V_T$ du canal du deuxième transistor $T_{21}$, on peut faire varier le potentiel appliqué sur la grille 108 du transistor $T_{11}$ de niveau inférieur.

La grille du premier transistor $T_{11}$ permet ainsi de commander le potentiel de canal du transistor $T_{21}$ de niveau supérieur.

Le premier transistor $T_{11}$ et le deuxième transistor $T_{21}$ sont disposés de sorte que la grille 108 du premier transistor $T_{11}$ est située en regard de la zone semi-conductrice 116 de canal du deuxième transistor $T_{21}$. Dans cet exemple, les grilles 108 et 118 ont des motifs alignés dans une direction orthogonale au plan principal du substrat (dans une direction parallèle à celle du vecteur $\vec{j}$ du repère orthogonal $[0; \vec{i}; \vec{j}; \vec{k}]$).

De préférence, pour obtenir un meilleur contrôle du potentiel de canal du deuxième transistor $T_{21}$, l'intégralité de la zone de canal du premier transistor $T_{11}$ est disposée en regard de la zone semi-conductrice 116 de canal du deuxième transistor $T_{21}$.

La zone de canal 116 du deuxième transistor $T_{21}$ peut être réalisée dans une couche semi-conductrice totalement désertée, de manière à permettre un contrôle électrostatique au niveau du canal d'inversion permettant une variation de tension de seuil. La zone de canal 116 du deuxième transistor $T_{21}$ peut être formée dans une couche semi-conductrice d'épaisseur comprise par exemple entre 1 et 100 nm, ou par exemple entre 5 et 20 nanomètres. L'épaisseur choisie pour la couche semi-conductrice dans laquelle est réalisée le canal 116 est prévue notamment en fonction du niveau de dopage de cette couche pour permettre un comportement totalement déplété.

Les zones de canal des transistors $T_{11}$ et $T_{21}$ peuvent être formées par exemple dans du Si ou dans un autre matériau semi-conducteur, par exemple tel que du Ge.

La zone isolante séparant la grille du transistor $T_{11}$ à la couche semi-conductrice sur laquelle le transistor $T_{21}$ est réalisé, est prévue pour permettre un couplage significatif de la grille 108 avec la zone de canal 116.

Par couplage significatif, on entend un couplage permettant de faire varier la tension de seuil du transistor $T_{21}$ de niveau supérieur d'au moins 50 mV, pour une variation de la tension appliquée à la grille du transistor $T_{11}$ de niveau inférieur entre 0 et Vdd ou -Vdd et +Vdd selon l'application, avec Vdd la tension d'alimentation du dispositif, par exemple de l'ordre de 1 Volt ou de 0.5 V.

Un modèle tel que celui décrit dans l'article de Lim et Fossum : IEEE Transactions on electron devices, vol. ED-30, n°10 Octobre 1983, peut être utilisé pour dimensionner la zone isolante 120 afin d'obtenir une variation de tension de seuil désirée ∆Vth lorsque l'on fait varier de ∆V le potentiel de polarisation de la grille 108 du premier transistor $T_{11}$.

Un tel modèle peut être utilisé en particulier dans le cas où le deuxième transistor $T_{21}$ est réalisé sur une couche totalement désertée.

$$\Delta V_{th} = \frac{\dfrac{\varepsilon_{sc}}{T_{sc}} \cdot \dfrac{\varepsilon_{ILD}}{T_{ILD}}}{\dfrac{\varepsilon_{ox}}{T_{ox}} \cdot \left( \dfrac{\varepsilon_{sc}}{T_{sc}} + \dfrac{\varepsilon_{ILD}}{T_{ILD}} \right)} \cdot \Delta V$$

Avec :

- ∆Vth la variation de tension de seuil du deuxième transistor $T_{21}$,
- $\varepsilon_{sc}$, $T_{sc}$, respectivement la permittivité diélectrique et l'épaisseur de la couche semi-conductrice dans laquelle le canal 116 du transistor $T_{21}$ est réalisé,
- $\varepsilon_{ox}$, $T_{ox}$, respectivement la permittivité diélectrique et l'épaisseur du diélectrique de grille du deuxième transistor $T_{21}$,
- $\varepsilon_{ILD}$, $T_{ILD}$, respectivement la permittivité diélectrique et l'épaisseur du diélectrique de la zone isolante 120 séparant la couche semi-conductrice du deuxième transistor $T_{21}$ de la grille 108 du premier transistor $T_{11}$.

Cela donne, lorsque le potentiel de la grille du premier transistor inférieur $T_{11}$ varie de 0 à Vdd :

$$\Delta V_{th} = \frac{\dfrac{\varepsilon_{sc}}{T_{sc}} \cdot \dfrac{\varepsilon_{ILD}}{T_{ILD}}}{\dfrac{\varepsilon_{ox}}{T_{ox}} \cdot \left( \dfrac{\varepsilon_{sc}}{T_{sc}} + \dfrac{\varepsilon_{ILD}}{T_{ILD}} \right)} \cdot V_{DD} \qquad (1)$$

Pour atteindre un couplage significatif correspondant à une variation de tension de seuil ∆Vth = 50mV, dans le cas où les grilles 108 et 118 ont une dimension critique de l'ordre de 45 nm, que l'épaisseur $T_{sc}$ de la zone de canal 116 est égale à 7 nm, que cette dernière est en silicium, que l'épaisseur $T_{ox}$ de la zone de diélectrique 117 est égale à 1 nm, que cette dernière est à base de $SiO_2$, que Vdd = 1V, et que la zone 120 est en $SiO_2$, la zone isolante 120 est prévue par exemple avec une épaisseur de l'ordre 17,5 nm.

Pour atteindre par exemple un couplage identique avec une zone isolante séparant les transistors superposés à base de $HfO_2$ avec une permittivité de 20, l'épaisseur physique de la couche de « high-k » est de l'ordre 90,5 nm.

Dans le cas où le diélectrique de la zone isolante 120 est à base d'un matériau « high-k », l'épaisseur $T_{high-k}$ à prévoir pour cette zone isolante 120 est déterminée par la formule précédente, en remplaçant Tox par :

$$Tox = \frac{\varepsilon_{SiO2}}{\varepsilon_{high-k}} \cdot T_{high-k}$$

Le premier transistor $T_{11}$ et le deuxième transistor $T_{21}$, peuvent être également dotés de zones d'accès au canal siliciurées.

Le premier transistor $T_{11}$ et le deuxième transistor $T_{21}$ peuvent être des transistors d'une cellule mémoire, en particulier d'une cellule mémoire SRAM.

Une modification dynamique de la tension de seuil $V_T$ du deuxième transistor peut être obtenue à l'aide de moyens (non représentés sur la figure 5) pour appliquer un potentiel variable, prévus pour :

- lors d'une phase, appliquer un potentiel sur la grille du premier transistor,
- lors d'une autre phase, appliquer un autre potentiel sur la grille du premier transistor.

Selon une possibilité de mise en oeuvre, pendant la première phase, le premier transistor peut être mis à l'état passant, tandis que pendant la deuxième phase, le premier transistor peut être mis à l'état bloqué.

La zone isolante 120 peut également avoir une composition et une épaisseur e'$_c$ > ec dans une région R2 située entre les zones d'accès du premier transistor T$_{11}$ et du deuxième transistor T$_{21}$, choisies pour permettre d'empêcher un couplage parasite entre les zones d'accès respectives des transistors T$_{11}$ et T$_{21}$.

Dans l'exemple de dispositif illustré sur la figure 5, une zone métallique de contact 180 commune entre les zones actives des transistors T$_{11}$ et T$_{21}$ est prévue. Cette zone de contact peut être par exemple une zone de contact 180 de source commune.

Le dispositif comporte également une zone métallique de contact 182 prévue par exemple pour le drain du deuxième transistor T$_{21}$, ainsi qu'une zone métallique de contact par exemple pour le drain du premier transistor T$_{11}$.

Dans l'exemple de la figure 5, la région de la zone isolante 120 séparant les zones d'accès du premier transistor et du deuxième transistor, est prévue, de par son épaisseur e'$_c$ et sa composition de manière à permettre de limiter un couplage parasite entre les zones d'accès du premier transistor T$_{11}$ et du deuxième transistor T$_{21}$.

Un exemple de dispositif microélectronique avec deux transistors, vient d'être décrit.

Un dispositif suivant l'invention peut comprendre un nombre plus élevés de transistors, par exemple un nombre n (avec n un entier tel que n > 2) de transistors T$_{11}$, T$_{21}$, T$_{(n-1)1}$, T$_{n1}$ superposés, chaque transistor T$_k$ d'un niveau donné N$_k$ (avec k un entier tel que 1 < k < n) comportant une zone de canal susceptible d'être couplée à l'électrode de grille d'un transistor T$_{k-1}$ de niveau N$_{k-1}$ inférieur au niveau donné N$_k$, cette grille étant située en regard de ladite zone de canal, à une distance prédéterminée suffisamment faible pour permettre un tel couplage (figure 6).

Plusieurs transistors peuvent être prévus au sein d'un même niveau du dispositif, éventuellement plusieurs transistors de même type, N ou P, ou des transistors de types différents.

Dans un tel dispositif, la zone semi-conductrice de canal d'un transistor est séparée de l'électrode de grille d'un transistor de niveau inférieur N$_{k-1}$ par l'intermédiaire d'un diélectrique inter-niveau, dont l'épaisseur est prévue suffisamment faible pour permettre un couplage entre la grille du transistor dudit niveau inférieur N$_{k-1}$ et le canal du transistor de niveau supérieur N$_k$. Cette épaisseur dépend notamment de la gamme de tension selon laquelle on souhaite moduler la tension de seuil V$_T$ du transistor de niveau supérieur.

Pour mettre en oeuvre un dispositif microélectronique suivant l'invention, on peut partir d'une technologie particulière, associée à un ensemble de paramètres prédéfinis, tels que par exemple la dimension critique de grille, la gamme de tension d'alimentation utilisée, puis en fonction de ces paramètres prédéfinis, on détermine l'épaisseur et le matériau de la zone isolante destinée à séparer les transistors superposés afin de permettre un couplage adéquat (c'est-à-dire permettant une variation de V$_T$ recherchée d'au moins par exemple d'au moins 50 mV). L'épaisseur et le matériau de la zone isolante peuvent être déterminés à l'aide d'un modèle tel que celui défini par la formule (1) donnée plus haut.

Dans un tel dispositif, le transistor T$_{11}$ du niveau N$_1$ le plus bas a une tension de seuil fixe dans la mesure où il repose directement sur le substrat.

Sur la figure 7, une variante de l'exemple de dispositif décrit en liaison avec la figure 5 est donnée. Pour cette variante, des transistors superposés T$_{12}$ et T$_{22}$, ont des grilles 218, 318, dont les centres respectifs ne sont pas alignés dans une direction orthogonale au plan principal du substrat.

Le premier transistor T$_{12}$ comporte une grille 218, de largeur W$_1$, tandis que le deuxième transistor T$_{22}$ situé au dessus du premier transistor T$_{12}$, est doté d'une grille de largeur W$_2$ supérieure à celle du premier transistor T$_{12}$.

Pour favoriser le couplage entre la grille du premier transistor et la zone de canal du deuxième transistor, le dessus ou la face supérieure de la grille du premier transistor est située en regard de la zone de canal du deuxième transistor, bien que les deux grilles aient des largeurs différentes et soient décentrées.

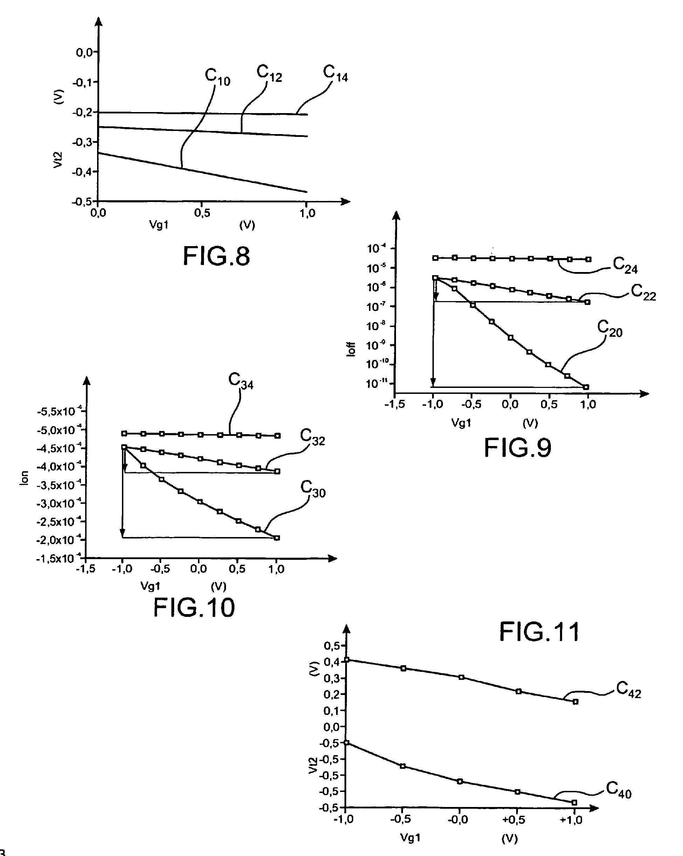

Sur les figures 8 à 10, des courbes C$_{10}$, C$_{20}$, C$_{30}$, illustrent le phénomène de couplage dans un dispositif microélectronique suivant l'invention, du type de celui décrit par exemple en liaison avec la figure 5. Le couplage est mis en oeuvre entre une grille du premier transistor T$_{11}$ et le canal du deuxième transistor T$_{21}$ situé au dessus du premier transistor T$_{11}$, la grille du premier transistor et le canal du deuxième transistor étant séparés par une épaisseur de matériau diélectrique, par exemple de l'ordre de 10 nanomètres.

Si l'on polarise la grille du premier transistor T$_{11}$, et que l'on fait varier, par exemple entre 0 et 1 V, le potentiel Vg1 appliqué sur cette grille, on observe une modification de la tension de seuil Vt2 du deuxième transistor T$_{21}$. Ce phénomène est illustré sur la courbe C$_{10}$ de la figure 8. Pour une telle variation du potentiel Vg1, on peut obtenir une variation de Vt2 de l'ordre de 130 mV.

A titre de comparaison, des courbes C$_{12}$ et C$_{14}$ montrent l'évolution de la tension de seuil de transistors dans des dispositifs d'agencement semblable, mais dans lesquels l'épaisseur de diélectrique T$_{ILD}$ entre la grille du premier transistor et la zone de canal est plus importante (T$_{ILD}$ = 50 nanomètres pour le dispositif de la courbe C$_{12}$ et T$_{ILD}$ = 300 nanomètres pour celui de la courbe C$_{14}$) et empêche ou réduit fortement le couplage.

La figure 9 montre, quant à elle, que dans un dispositif, par exemple du type de celui de la figure 5, une variation du potentiel Vg1 de la grille du premier transistor T$_{11}$, de -1V à 1V, peut entraîner une variation $\delta I_{OFF}$ du courant I$_{OFF}$ à l'état bloqué, de l'ordre de 6 décades (courbe C$_{20}$ sur la figure 9). A titre de comparaison, des courbes C$_{22}$ et C$_{24}$ sur cette même figure 9, montrent l'évolution du courant Ioff du deuxième transistor d'un dispositif d'agencement semblable, mais dont l'épaisseur de diélectrique $T_{ILD}$ entre la grille du premier transistor et la zone de canal du deuxième transistor ($T_{ILD}$ = 50 nanomètres pour celui de la courbe $C_{22}$ et $T_{ILD}$ = 300 nanomètres pour celui de la courbe $C_{24}$) est plus importante et empêche ou réduit fortement le couplage.

La figure 10 montre, quant à elle, que dans un dispositif, par exemple du type de celui de la figure 5, une variation du potentiel Vg1 de la grille du premier transistor $T_{11}$, de -1V à 1V, peut entraîner une variation $\delta I_{ON}$ du courant $I_{ON}$ dans le canal du deuxième transistor, de l'ordre de 53 %, lorsque ce dernier est à l'état passant (courbe $C_{30}$ sur la figure 10) . A titre de comparaison, des courbes $C_{22}$ et $C_{24}$ sur cette même figure 8, montrent l'évolution du courant $I_{ON}$ du deuxième transistor dans des dispositifs d'agencement semblable, mais dont les épaisseurs $T_{ILD}$ respectives de diélectrique entre la grille du premier transistor et la zone de canal ($T_{ILD}$ = 50 nanomètres pour la courbe $C_{22}$ et $T_{ILD}$ = 300 nanomètres pour la courbe $C_{29}$) empêchent ou réduit fortement le couplage.

Une modification dynamique de la tension de seuil $V_T$ d'un transistor donné du dispositif microélectronique consiste, par exemple :

- à imposer, lors d'une première phase, à l'aide d'un premier potentiel donné V1 appliqué sur la grille d'un autre transistor situé sous le transistor donné, une tension de seuil VT élevée lorsque le transistor donné est à l'état bloqué,
- à imposer, lors d'une deuxième phase, à l'aide d'un deuxième potentiel donné V2 appliqué sur la grille dudit autre transistor, une tension de seuil VT faible lorsque le transistor est à l'état passant.

La courbe $C_{40}$ illustre le phénomène de couplage dans un dispositif microélectronique , entre une grille d'un premier transistor portée à un potentiel Vg1 variant entre -1V et 1V et un canal d'un deuxième transistor PMOS situé au dessus du premier transistor, la grille du premier transistor et le canal du deuxième transistor étant séparés par une épaisseur de matériau diélectrique équivalente en $SiO_2$, de l'ordre de 10 nanomètres.

La courbe $C_{42}$ illustre quant à elle le phénomène de couplage dans un dispositif microélectronique, entre une grille d'un premier transistor portée à un potentiel Vg1 variant entre -1V et 1V et un canal d'un deuxième transistor NMOS situé au dessus du premier transistor, la grille du premier transistor et le canal du deuxième transistor étant séparés par une épaisseur de matériau diélectrique $T_{ILD}$, par exemple du $SiO_2$ de l'ordre de 10 nanomètres.

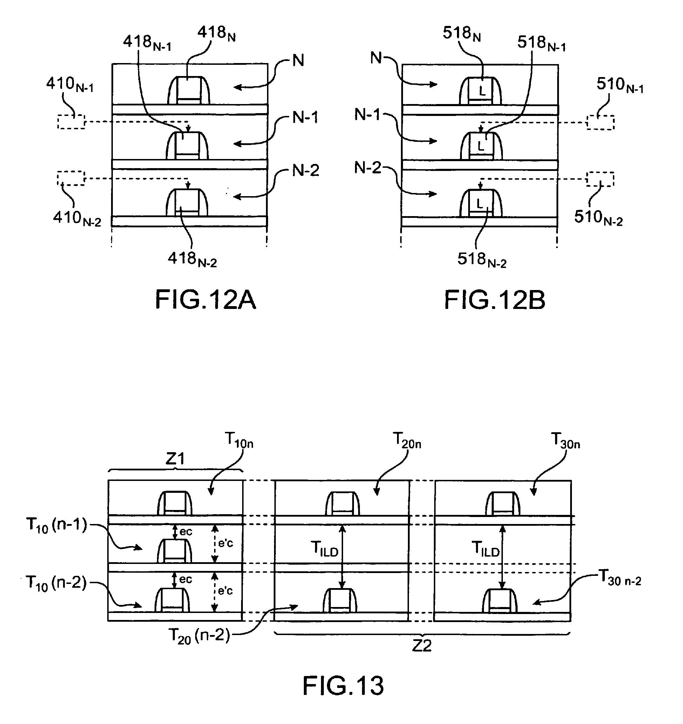

Sur la figure 12A, les 3 derniers étages d'un dispositif microélectronique (du type de ceux décrits précédemment en liaison avec les figures 5 et 6) à N étages de transistors superposés sont représentés.

La grille du transistor du N-1ème étage est reliée ou connectée à des moyens de polarisation $410_{N-1}$, ce qui permet d'influer par couplage, sur le potentiel du canal du transistor de l'étage N supérieur.

De même, la grille du transistor du N-2ème étage est reliée ou connectée à des moyens de polarisation $410_{N-2}$, ce qui permet d'influer, par couplage, sur le potentiel du canal du transistor du N-1ème étage.

Les moyens de polarisation $410_N$ et $410_{N-1}$ sont prévus pour appliquer un potentiel de polarisation qui peut être variable. Dans cet exemple, les transistors sont tous fonctionnels et peuvent jouer le rôle d'interrupteur, par exemple dans un mémoire ou dans une porte logique. Le potentiel appliqué peut être un potentiel positif compris entre deux valeurs données de potentiels, 0 et Vdd avec Vdd un potentiel d'alimentation du dispositif par exemple de l'ordre de 1 V ou de 0,1 V.

Sur la figure 12B, une variante de l'exemple de configuration qui vient d'être décrite est donnée. Pour cette variante, la superposition de transistors comporte un transistor 500 au N-1ème étage qui n'est pas utilisé pour fonctionner en interrupteur mais seulement comme moyen pour faire varier le potentiel du canal du transistor situé au Nième étage, en fonction de la manière dont sa grille est polarisée.

La grille du transistor 500 situé au N-1ème étage est reliée ou connectée à des moyens de polarisation $510_{N-1}$, ce qui permet d'influer, par couplage, sur le potentiel du canal du transistor de l'étage N supérieur.

De même, la grille du transistor du N-2ème étage est reliée ou connectée à des moyens de polarisation $410_{N-2}$, ce qui permet d'influer, par couplage, sur le potentiel du canal du transistor du N-1ème étage.

Les moyens de polarisation $510_{N-1}$ sont dans cet exemple prévus pour appliquer un potentiel de polarisation qui peut être compris dans une deuxième gamme de valeurs de potentiels négatifs et positifs, dans la mesure où le transistor 500 est utilisé pour le couplage à l'aide de sa grille plutôt que pour sa fonction de transistor. La deuxième gamme de valeurs peut être par exemple comprise entre -Vdd et Vdd, avec Vdd le potentiel d'alimentation du dispositif, par exemple de l'ordre de 1V ou de 0,1V.

De même, la grille du transistor du N-2ème étage est reliée ou connectée à des moyens de polarisation $510_{N-2}$, ce qui permet d'influer, par couplage, sur le potentiel du canal du transistor du N-1ème étage.

Les moyens de polarisation $510_{N-2}$ sont, dans cet exemple, prévus pour appliquer un potentiel de polarisation qui peut être positif et compris dans une gamme de potentiels, par exemple entre 0 et Vdd, avec Vdd un potentiel d'alimentation du dispositif.

Un autre exemple de dispositif microélectronique avec plusieurs niveaux de transistors superposés, est donné sur la figure 13.

Ce dispositif comprend une première zone Z1, comportant plusieurs transistors $T_{10n}$, $T_{10(n-1)}$ dont les zones de canal sont couplées respectivement aux grilles de transistors $T_{10(n-1)}$, $T_{10(n-2)}$ de niveau inférieur. Ce dispositif comprend également une deuxième zone Z2,

comportant plusieurs transistors $T_{20n}$, $T_{30(n-1)}$ d'un même niveau dont les zones de canal ne sont pas couplées aux grilles des transistors $T_{20(n-2)}$, $T_{30(n-2)}$ de niveau inférieur.

Ainsi le dispositif comporte une première zone Z1 où un couplage entre transistors est mis en oeuvre, et une autre zone Z2, à côté de la première zone Z1, où les transistors superposés sont découplés.

Le dispositif peut comporter ainsi une première zone Z1 où on réalise une modulation de la tension de seuil de certains transistors et une autre zone Z2, à côté de la première zone Z1, où les transistors ont une tension de seuil fixe.

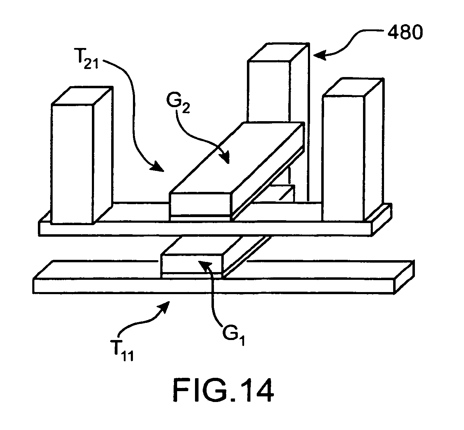

Une variante de l'exemple de dispositif décrit en liaison avec la figure 5, prévoit une zone de contact 480 entre la grille G1 du premier transistor $T_{11}$ et la grille G2 du deuxième transistor $T_{21}$ (figure 14).

Avec un tel dispositif, on peut obtenir un courant Ion plus élevé dans le canal du deuxième transistor T21 sans augmenter le courant Ioff à l'état bloqué, en modifiant dynamiquement la tension de seuil du deuxième transistor T21.

Le premier transistor T11 peut être utilisé en tant que grille de contrôle de la tension de seuil du transistor T21 du niveau supérieur.

En effet, en prenant l'exemple d'un transistor de type N,

On définit la tension de seuil standard d'un nMOS par $Vt_{s,n}$= Vt (Vg1=0).

A l'état passant :

Les potentiels Vg2 et Vg1 appliqués sur les grilles G1 et G2 sont tels que Vg2=Vg1=Vdd

Selon les résultats de simulation de la figure 11, la tension de seuil du deuxième transistor T21 est abaissée :

Vt$_{on}$<Vt, ce qui permet d'obtenir un courant Ion plus important.

A l'état bloqué :

Les potentiels Vg2 et Vg1 appliqués sur les grilles G1 et G2 sont tels que Vg2=Vg1=0.

Dans ce cas, la tension de seuil reprend une valeur standard et le courant Ioff reste faible.

La structure proposée permet d'améliorer le courant à l'état passant sans dégrader le courant à l'état bloqué.

Une application possible pour l'un ou l'autre des exemples de dispositifs microélectroniques est la mise en oeuvre de cellules mémoires améliorées, en particulier de cellules SRAM améliorées.

De telles cellules peuvent ainsi comporter une pluralité de transistors superposés, dont un ou plusieurs transistors ont une grille, qui, suivant la manière dont elle est polarisée, permet de moduler la tension de seuil $V_T$

d'un transistor dont la zone de canal est située au dessus et en regard de ladite grille, à une distance permettant un couplage entre ladite grille et ladite zone de canal.

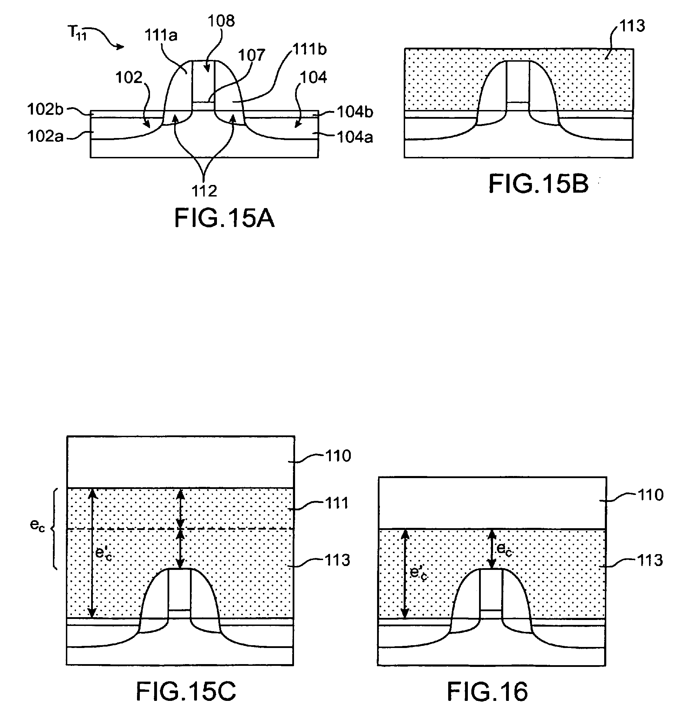

Un exemple de procédé de réalisation d'un dispositif microélectronique tel que décrit en liaison avec la figure 5, va à présent être donné en liaison avec les figures 15A-15C et 16.

On réalise tout d'abord (figure 15A) sur un substrat 100, une structure de transistor $T_{11}$ comportant une région de source 102, une région de drain 104, ainsi qu'une zone 106 de canal, reliant la région de source 102 et la région de drain 104, une zone de diélectrique 107 de grille et une grille 108 sur la zone 107 de diélectrique de grille. Des espaceurs isolants 111a, 111b peuvent être également réalisés de part et d'autre de la grille 108. La réalisation des zones de source et de drain peut comprendre la formation de zones semi-conductrices fortement dopées 102a, 104a communément appelées HDD (HDD pour « Highly doped drain »), surmontées de zones siliciurées 102b, 104b. Des zones d'accès 112 au canal faiblement dopées, communément appelées zones LDD (LDD pour « lightly doped drain ») peuvent être également réalisées.

Ensuite, on recouvre le transistor d'une couche 113 de matériau diélectrique, par exemple à base d'un matériau « high-k » tel que du HfO$_2$ ou de SiO$_2$. (figure 15B) que l'on peut ensuite planariser par exemple par polissage mécano-chimique (CMP).

Puis, on reporte, par exemple par collage, une couche semi-conductrice 110 recouverte par une couche isolante 111 sur la couche 113, de manière à mettre en contact les couches isolantes 111 et 113. L'épaisseur cumulée ec des couches isolantes 111 et 113 au dessus de la grille 108, est prédéterminée, et prévue de manière à ce qu'un couplage entre la grille 108 du transistor 111 et une zone de canal destinée à être formée dans la couche semi-conductrice 110, puisse être mis en oeuvre.

L'épaisseur cumulée peut être comprise entre 1 et 50 nanomètres équivalente en SiO$_2$ (figure 15C).

Selon une variante on peut reporter, par exemple par collage, une couche semi-conductrice 110 directement sur la couche 113. L'épaisseur ec de la couche isolante 113 au dessus de la grille 108, est alors également prédéterminée, et prévue de manière à permettre ultérieurement, un couplage entre la grille 108 du transistor 111 et une zone de canal destinée à être formée dans la couche semi-conductrice 110 (figure 16).

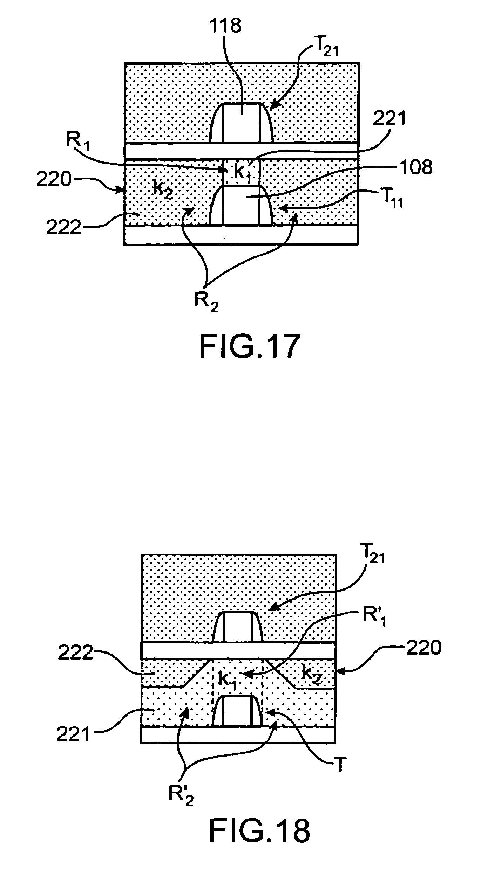

Un dispositif microélectronique à transistors superposés, mis en oeuvre suivant l'invention, va à présent être décrit en liaison avec les figures 17 et 18.

Ce dispositif diffère de celui décrit précédemment en liaison avec la figure 5, en ce qu'il comporte, entre les transistors $T_{11}$ et $T_{21}$, une zone isolante 220 formée de plusieurs matériaux diélectriques différents 221, 222, en particulier ayant des constantes diélectriques différentes k1, k2. L'épaisseur et la répartition desdits matériaux diélectriques 221, 222, sont prévues de manière à permettre un couplage dans une première ré-

gion $R_1$ située entre la grille du premier transistor $T_{11}$ et le canal du deuxième transistor $T_{21}$, et de limiter le couplage entre les transistors $T_{11}$ et $T_{21}$ dans une région R2 située autour de cette première région R1.

Un premier exemple de réalisation est donné sur la figure 17, dans lequel la grille 108 du premier transistor $T_{11}$ et la zone de canal 116 du deuxième transistor $T_{21}$ sont séparées par un premier matériau diélectrique 221 ayant une première constante diélectrique $k_1$.

De part et d'autre de cette première région R1, au-dessus des régions de source et de drain du premier transistor $T_{11}$, la zone isolante 220 est formée à base d'un deuxième matériau diélectrique 222 ayant une deuxième constante diélectrique $k_2$, telle que $k_2 < k_1$. La première région R1 peut être remplie d'un matériau diélectrique « high-k » par exemple tel que du $HfO_2$ d'épaisseur par exemple de l'ordre de 40 nanomètres, tandis que la région située autour de cette première région peut être remplie d'un matériau diélectrique d'épaisseur par exemple de l'ordre de 100 nanomètres, de constante diélectrique plus faible tel que du $SiO_2$.

Avec un tel dispositif, en fonction de la manière dont la polarisation de la grille 108 du premier transistor $T_{11}$ est prévue, la tension de seuil $V_T$ du canal du deuxième transistor $T_{21}$ peut être ajustée. La grille du premier transistor $T_{11}$ permet ainsi de commander le potentiel de canal du transistor $T_{21}$ de niveau supérieur. On évite cependant les phénomènes de couplage du deuxième transistor $T_{21}$ avec le premier transistor $T_{11}$ dans des zones situées en dehors du canal du deuxième transistor $T_{22}$. Ainsi, les zones d'accès des transistors $T_{11}$ et $T_{21}$ peuvent être totalement découplées entre elles.

Dans ce premier exemple, un premier bloc de matériau diélectrique 221 de constante diélectrique $k_1$ recouvre la grille 108 du transistor $T_{11}$ inférieur. Le matériau diélectrique 221 de forte permittivité est formé uniquement au-dessus la grille 108 du transistor $T_{11}$ inférieur, tandis que des blocs de matériau diélectrique 222 de constante diélectrique $k_2$ et ayant une plus faible permittivité, séparent les zones d'accès respectives des transistors $T_{11}$ et $T_{21}$.

La première région R1 a ainsi de par sa constitution et son épaisseur, une capacité électrique C1 prévue inférieure à la capacité C2 de la région R2 dont la constitution et l'épaisseur sont différentes.

Un deuxième exemple de réalisation est donné sur la figure 18. Comme dans l'exemple décrit précédemment en liaison avec la figure 17, ce dispositif comporte une zone isolante 220 séparant les transistors $T_{11}$ et $T_{21}$, formée de plusieurs matériaux diélectriques différents 221, 222, et dont l'épaisseur et la composition varie suivant la région dans laquelle on se trouve entre les transistors $T_{11}$ et $T_{21}$.

La grille 108 du premier transistor $T_{11}$ et la zone de canal 116 du deuxième transistor $T_{21}$ sont séparées par une première région R1 à base d'un premier matériau diélectrique 221, par exemple un matériau diélectrique ayant une première constante diélectrique $k_1$. Autour de cette première région R1, dans une région R2 située au dessus des régions de source et de drain du premier transistor $T_{11}$ sont prévus des blocs isolants formés d'un empilement du premier matériau diélectrique 221 et d'un deuxième matériau diélectrique 222 ayant une deuxième constante diélectrique $k_2$, telle que $k_2 < k_1$. La première région diélectrique R1 de la zone 220 a ainsi, de par sa constitution et son épaisseur, une capacité électrique C1 prévue inférieure à la capacité C2 de la région R2 diélectrique de la zone 220 dont la constitution et l'épaisseur sont différentes.

Avec un tel dispositif, en fonction de la manière dont la polarisation de la grille 108 du premier transistor $T_{11}$ est prévue, la tension de seuil $V_T$ du canal du deuxième transistor $T_{21}$ peut être ajustée. La grille du premier transistor $T_{11}$ permet ainsi de commander le potentiel de canal du transistor $T_{21}$ de niveau supérieur. On évite également les phénomènes de couplage du deuxième transistor $T_{21}$ avec le premier transistor $T_{11}$ dans la deuxième région R2. Les zones d'accès des transistors $T_{11}$ et $T_{21}$ peuvent être ainsi totalement découplées entre elles.

Dans les deux exemples qui viennent d'être donnés l'épaisseur et la composition de la zone isolante 220 séparant les deux transistors est variable, et diffère entre une première région R1 située entre la grille du premier transistor $T_{11}$ et la zone de canal du deuxième transistor, et une autre région R2 située autour de la première région R1 entre les zones d'accès des deux transistors $T_{11}$ et $T_{21}$.

La zone isolante 220 a une composition et une épaisseur dans la région R1, choisies de manière à permettre un couplage significatif entre la grille 108 du transistor $T_{11}$ et la zone de canal du transistor $T_{21}$.

La zone isolante 220 a une composition et une épaisseur dans la région R2 située entre les zones d'accès du premier transistor $T_{11}$ et du deuxième transistor $T_{21}$, choisies de manière à limiter un couplage parasite entre les zones d'accès respectives des transistors $T_{11}$ et $T_{21}$.

Un dispositif tel que décrit en liaison avec les figures 17 et 18 présente des améliorations en termes de performances électriques par rapport à un dispositif à transistors superposés dans lequel, on met en oeuvre un couplage de la grille d'un transistor inférieur avec un transistor de niveau supérieur, sans se préoccuper d'isoler entre elles les zones d'accès des transistors.

Par rapport à un dispositif tel que décrit en liaison avec la figure 5, un dispositif ayant du type de celui décrit en liaison avec les figures 17 et 18, présente des améliorations en termes d'encombrement. Dans le dispositif décrit en liaison avec les figures 17 et 18, pour obtenir l'effet de couplage recherché tout en évitant des couplages parasites, une distance e'c entre les zones d'accès des transistors T11 et T21, et/ou une épaisseur de grille du transistor T11 et/ou une distance ec entre la grille du transistor T11 et le canal du transistor T21, plus faible que dans le dispositif de la figure 5, peut être prévue.

Pour le dispositif de la figure 17, lorsque l'épaisseur diélectrique totale au niveau de la région R2 est de l'ordre de 3 fois l'épaisseur de la première région R1 et que le premier diélectrique est un high-k tel que du $HfO_2$, tandis que le deuxième matériau diélectrique est du $SiO_2$, on peut obtenir une capacité entre la grille du premier transistor et le canal du deuxième transistor, de l'ordre de 15 fois celle entre une zone d'accès du premier transistor et une zone d'accès du deuxième transistor située au dessus.

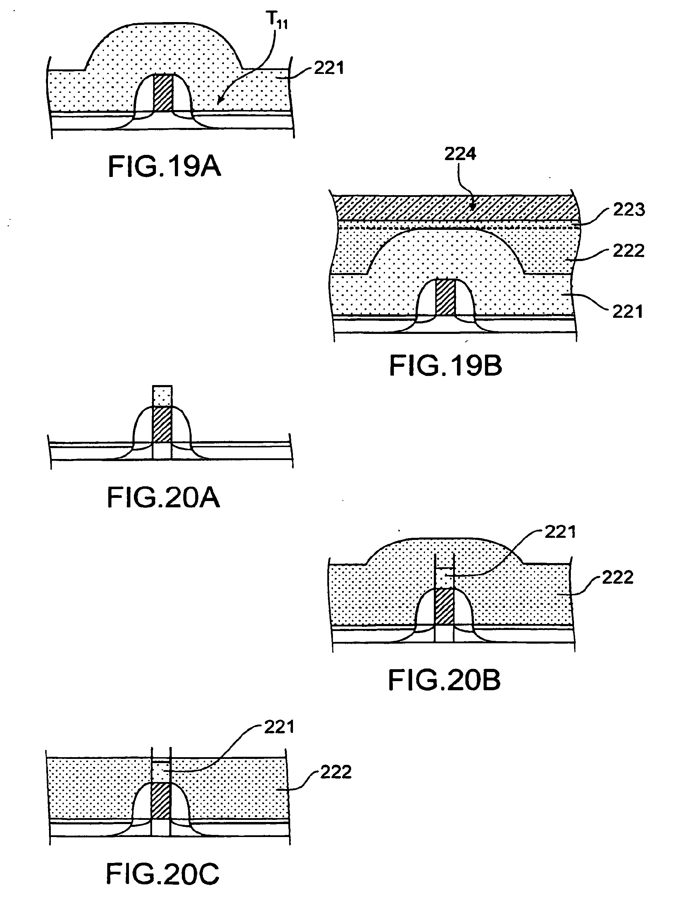

Un exemple de procédé de réalisation d'un dispositif microélectronique tel que décrit en liaison avec la figure 18, est donné sur les figures 19A-19B.

On réalise tout d'abord sur un substrat 100, une structure de transistor $T_{11}$ comportant des zones d'accès, c'est-à-dire une région de source et une région de drain, ainsi qu'une zone de canal entre les zones d'accès, une zone de diélectrique de grille sur la zone de canal et une grille sur la zone de diélectrique de grille. Des espaceurs isolants peuvent être également réalisés de part et d'autre de la grille 108.

Ensuite, on recouvre le transistor d'une couche d'un premier matériau diélectrique 221 de constante diélectrique $k_1$, par exemple à base d'un matériau « high-k » tel que du $HfO_2$. Le dépôt du premier matériau diélectrique 221 peut être conforme (figure 19A).

Puis, on dépose une couche d'un deuxième matériau diélectrique 222 de constante diélectrique $k_2$, par exemple un matériau 222 de plus faible permittivité que le premier matériau 221, par exemple du $SiO_2$.

On peut effectuer ensuite une planarisation de la couche de matériau diélectrique 222, par exemple par polissage de type CMP. Le polissage peut être effectué de manière à se servir de la couche de matériau diélectrique 221 comme couche d'arrêt.

Puis, on reporte, par exemple par collage, une couche semi-conductrice, qui peut être recouverte par une couche isolante 223 de manière à mettre en contact les couches isolante 223 et la couche de matériau diélectrique 222. La couche isolante 223 peut être à base du même matériau que le deuxième matériau diélectrique. L'épaisseur isolante cumulée au dessus de la grille du transistor $T_{11}$, est prédéterminée, et prévue de manière à ce qu'un couplage entre la grille du transistor et une zone de canal destinée à être formée dans la couche semi-conductrice 224, puisse être mis en oeuvre.

Selon une variante on peut reporter, par exemple par collage, la couche semi-conductrice directement sur la couche de matériau diélectrique 222.

Un autre exemple de procédé de réalisation d'un dispositif microélectronique tel que décrit en liaison avec la figure 17, est donné sur les figures 20A-20C.

On réalise tout d'abord sur un substrat 100, une structure de transistor $T_{11}$.

Ensuite, on recouvre le transistor d'une couche d'un premier matériau diélectrique 221 de constante diélectrique $k_1$, par exemple par dépôt conforme d'un matériau « high-k » tel que du $HfO_2$.

Puis on grave le matériau diélectrique 221, de manière à retirer ce matériau 221 des zones d'accès du transistor, et à conserver un bloc de matériau diélectrique 221 uniquement sur la grille du transistor $T_{11}$ (figure 20A).

Ensuite, on dépose une couche d'un deuxième matériau diélectrique 222 de constante diélectrique $k_2$, par exemple un matériau 222 de plus faible permittivité que le premier matériau 221, par exemple du $SiO_2$. Le dépôt peut être conforme et réalisé de manière à recouvrir les zones d'accès du transistor T11, ainsi que le bloc de matériau diélectrique 221 formé sur la grille du transistor (figure 20B).

On peut effectuer ensuite une planarisation de la couche de matériau diélectrique 222, par exemple par polissage de type CMP (figure 20C). Le polissage peut être effectué de manière à se servir de la couche de matériau diélectrique 221 comme couche d'arrêt.

Puis, on reporte par exemple par collage, une couche semi-conductrice, à partir de laquelle on forme ensuite le deuxième transistor (étapes non représentées).

## Revendications

1. Dispositif microélectronique comprenant :

   - un substrat (100) surmonté d'un empilement de couches,
   - au moins un premier transistor ($T_{11}$) situé à un niveau donné dudit empilement,
   - au moins un deuxième transistor ($T_{21}$) situé à un deuxième niveau dudit empilement, au dessus dudit niveau donné; le premier transistor ($T_{11}$) comportant une électrode de grille (108) située en regard d'une zone de canal (116) du deuxième transistor ($T_{21}$), le premier transistor et le deuxième transistor étant séparés par l'intermédiaire d'une zone isolante (220),

   ladite zone isolante étant constituée de plusieurs matériaux diélectriques différents (221, 222), et ayant dans une première région (R1) entre ladite grille dudit premier transistor et ledit canal dudit deuxième transistor, une composition et une épaisseur (ec) prévues de manière à former une première capacité électrique C1 entre l'électrode de grille du premier transistor et le canal du deuxième transistor, ladite zone isolante comportant une deuxième région (R2) de propriété diélectrique et d'épaisseur différentes de celles de la première région et située entre au moins une zone d'accès du premier transistor et au moins une zone d'accès du deuxième transistor, la composition et l'épaisseur (ec) de la deuxième région étant prévues de manière à former une deuxième capacité électrique C2 entre ladite zone d'accès du premier transistor et ladite zone d'accès du deuxième transistor, telle que C2 < C1.

**2.** Dispositif selon la revendication 1, ladite zone isolante ayant dans la première région. (R1), une composition et une épaisseur (ec) prévus de manière à permettre un couplage entre la grille du premier transistor (T11) et le canal du deuxième transistor (T21).

**3.** Dispositif selon la revendication 2, dans lequel ladite zone isolante (220) ayant dans la deuxième région (R2) entre ladite zone d'accès dudit premier transistor (T11) et ladite zone d'accès dudit deuxième transistor (T21), une composition et une épaisseur prévues de manière à limiter ou empêcher un couplage entre ladite zone d'accès du premier transistor et ladite zone d'accès du deuxième transistor.

**4.** Dispositif microélectronique selon l'une des revendications 2 ou 3, le couplage entre la grille du premier transistor et le canal du deuxième transistor étant tel qu'une variation du potentiel de grille du premier transistor ($T_{11}$) entraine une variation de la tension de seuil du deuxième transistor ($T_{21}$).

**5.** Dispositif microélectronique selon l'une des revendications 2 à 4, dans lequel Vdd est une tension d'alimentation du dispositif, le couplage entre la grille du premier transistor et le canal du deuxième transistor étant tel qu'une variation du potentiel de grille du premier transistor de 0 à Vdd, permette d'obtenir une variation de tension de seuil du deuxième transistor d'au moins 50 mV.

**6.** Dispositif microélectronique selon la revendication 5, ledit potentiel de grille, variant entre 0 et Vdd ou entre -Vdd et + Vdd.

**7.** Dispositif microélectronique selon l'une des revendications 1 à 6, dans lequel ladite première région (R1) est formée d'un premier matériau diélectrique (221) ayant une première constante diélectrique $k_1$, ladite deuxième région (R2) étant formée d'un deuxième matériau diélectrique (222) ayant une deuxième constante diélectrique $k_2$ telle que $k_2 < k_1$.

**8.** Dispositif microélectronique selon l'une des revendications 1 à 6, dans lequel ladite première région (R1) est formée d'un premier matériau diélectrique (221) ayant une première constante diélectrique $k_1$, ladite deuxième région (R2) comportant un empilement dudit premier matériau diélectrique (221) et d'un deuxième matériau diélectrique (222) ayant une deuxième constante diélectrique $k_2$ telle que $k_2 < k_1$.

**9.** Dispositif microélectronique salon l'une des revendications 1 à 6, dans lequel ladite première région (R1) est formée d'un premier empilement d'un premier matériau diélectrique (221) et d'un deuxième matériau diélectrique (222), ladite deuxième région (R2) comportant un deuxième empilement dudit premier matériau diélectrique (221) et du deuxième matériau diélectrique (222), les épaisseurs respectives du premier matériau diélectrique (221) et du deuxième matériau diélectrique (222) étant différentes dans le premier empilement et dans le deuxième empilement.

**10.** Dispositif microélectronique selon l'une des revendications 1 à 9, dans lequel ladite première région (R1) de la zone isolante (220) a une épaisseur équivalente en $SiO_2$ comprise entre 1 et 50 nanomètres.

**11.** Dispositif microélectronique selon l'une des revendications 1 à 10, le dispositif étant doté en outre : de moyens pour moduler la tension de seuil du deuxième transistor, comprenant des moyens de polarisation destinées à appliquer un potentiel variable sur ladite grille dudit premier transistor et prévus pour :

   - appliquer à la grille du premier transistors, pendant une première phase, au moins un premier potentiel,
   - appliquer à la grille du premier transistor, pendant une deuxième phase, au moins un deuxième potentiel, différent dudit premier potentiel.

**12.** Dispositif microélectronique selon la revendication 11, dans lequel ledit premier potentiel est prévu pour rendre passant ledit deuxième transistor et imposer une première tension de seuil au deuxième transistor, ledit deuxième potentiel étant prévu pour rendre bloqué ledit deuxième transistor et imposer une deuxième tension de seuil, supérieure à ladite première tension de seuil.

**13.** Dispositif microélectronique selon l'une des revendications 1 à 12, la zone de canal du premier transistor ($T_{11}$) étant située totalement en regard de la grille du deuxième transistor ($T_{21}$).

**14.** Dispositif microélectronique selon l'une des revendications 1 à 13, comportant en outre, dans un axe orthogonal au plan principal du substrat passant par la grille du premier transistor et/ou du deuxième transistor, un ou plusieurs autres transistors.

**15.** Dispositif microélectronique selon l'une des revendications 1 à 14, comprenant en outre :

   au moins un troisième transistor ($T_{21}$) situé au niveau dudit premier transistor dans ledit empilement, et au moins un quatrième transistor ($T_{21}$) situé au dessus troisième transistor, le quatrième transistor ($T_{21}$) et le troisième transistor étant séparés par l'intermédiaire d'une zone diélectrique prévue pour limiter ou empêcher un couplage entre le troisième transistor et le quatrième transistor.

**16.** Dispositif microélectronique selon l'une des revendications 1 à 15, comprenant en outre :

au moins un troisième transistor ($T_{21}$) situé au niveau dudit premier transistor dans ledit empilement, et au moins un quatrième transistor ($T_{21}$), un cinquième transistor ($T_{21}$) de découplage étant situé entre le troisième transistor et le quatrième transistor.

**17.** Dispositif microélectronique selon l'une des revendications 1 à 16 comprenant en outre :

un ou plusieurs autres transistors dans un plan parallèle au plan principal du substrat et passant par la grille (108) du premier transistor ($T_{11}$) et/ou la grille (118) du deuxième transistor ($T_{21}$).

**18.** Dispositif microélectronique selon l'une des revendication 1 à 17 comprenant en outre au moins un plot de contact entre la grille du premier transistor et la grille du deuxième transistor.

**19.** Dispositif microélectronique selon l'une des revendications 1 à 18, dans lequel les transistors appartiennent à une cellule mémoire SRAM.

**Claims**

**1.** Microelectronic device comprising:

- a substrate (100) surmounted by a stack of layers,
- at least one first transistor (T11) situated at a given level of said stack,
- at least one second transistor (T21) situated at a second level of said stack, above said given level, the first transistor comprising a gate electrode (108) situated opposite a channel zone (116) of the second transistor, the first transistor and the second transistor being separated by means of an insulating zone (220),

said insulating zone being constituted of several different dielectric materials (221,222) and having in a first region (R1) between said gate of said first transistor and said channel of said second transistor, a composition and a thickness provided so as to form a first electric capacitance C1 between the gate electrode of the first transistor and the channel of the second transistor, said insulating zone comprising a second region (R2) of dielectric properties and thickness different from the dielectric properties and thickness of the first region and situated between at least one access zone of the first transistor and at least one access zone of the second transistor, the composition and the thickness of the second region being provided so as to form a second electric capacitance C2 between said access zone of the first transistor and said access zone of the second transistor, such that C2 < C1.

**2.** Device according to claim 1, said insulating zone having in the first region (R1) a composition and a thickness (ec) provided so as to enable a coupling between the gate of the first transistor (T11) and the channel of the second transistor (T21).

**3.** Device according to claim 2, wherein said insulating zone (220) having, in the second region (R2) between said access zone of said first transistor (T11) and said access zone of said second transistor (T21), a composition and a thickness provided so as to limit or present a coupling between said access zone of the first transistor and said access zone of the second transistor.

**4.** Microelectronic device according to claim 2 or 3, the coupling between the gate of the first transistor and the channel of the second transistor being such that a variation in the gate potential of the first transistor ($T_{11}$) brings about a variation in the threshold voltage of the second transistor ($T_{21}$).

**5.** Microelectronic device according to claim 4, wherein Vdd is a supply voltage of the device, the coupling between the gate of the first transistor and the channel of the second transistor being such that a variation in gate potential of the first transistor between 0 to Vdd, makes it possible to obtain a variation in threshold voltage of the second transistor of at least 50 mV.

**6.** Microelectronic device according to claim 5, said gate potential varying between 0 and Vdd or between -Vdd and + Vdd.

**7.** Microelectronic device according to any of claims 1 to 6, wherein said first region is formed of a first dielectric material having a first dielectric constant $k_1$, a second region being formed of a second dielectric material having a second dielectric constant $k_2$ such that $k_2 < k_1$.

**8.** Microelectronic device according to any of claims 1 to 6, wherein said first region (R1) is formed of a first dielectric material (221) having a first dielectric constant $k_1$, a second region (R2) comprising a stack of said first dielectric material and a second dielectric material having a second dielectric constant $k_2$ such that $k_2 < k_1$.

**9.** Microelectronic device according to any of claims 1 to 6, wherein said first region (R1) is formed of a first stack of a first dielectric material (221) and a second dielectric material (222), a second region (R2) comprising a second stack of said first dielectric material (221) and the second dielectric material (222), the respective thicknesses of the first dielectric material (221) and the second dielectric material (222) being different in the first stack and in the second stack.

10. Microelectronic device according to any of claims 1 to 9, wherein said first region (R1) of the insulating zone (220) has an equivalent $SiO_2$ thickness between 1 and 50 nanometres.

11. Microelectronic device according to any of claims 1 to 10, the device being further provided with: means for modulating the threshold voltage of the second transistor, comprising polarisation means intended to apply a variable potential to said gate of said first transistor and provided:

> - to apply to the gate of the first transistor, during a first phase, at least one first potential,
> - to apply to the gate of the first transistor, during a second phrase, at least one second potential, different to said first potential.

12. Microelectronic device according to claim 11, wherein said first potential is provided to turn on said second transistor and impose a first threshold voltage on the second transistor, said second potential being provided to turn off said second transistor and impose a second threshold voltage, greater than said first threshold voltage.

13. Microelectronic device according to any of claims 1 to 12, the channel zone of the first transistor ($T_{11}$) being situated fully opposite the gate of the second transistor ($T_{21}$).

14. Microelectronic device according to any of claims 1 to 13, further comprising, in an axis orthogonal to the principal plane of the substrate passing through the gate of the first transistor and the second transistor, one or several other transistors.

15. Microelectronic device according to any of claims 1 to 14, further comprising: at least one third transistor ($T_{21}$) situated at the level of said first transistor in said stack, and at least one fourth transistor situated above the third transistor, the fourth transistor and the third transistor being separated by means of a dielectric zone provided to limit or present a coupling between the third transistor and the fourth transistor.

16. Microelectronic device according to any of claims 1 to 15, further comprising: at least one third transistor ($T_{21}$) situated at the level of said first transistor in said stack, and at least one fourth transistor ($T_{21}$), a fifth decoupling transistor being situated between the third transistor and the fourth transistor.

17. Microelectronic device according to any of claims 1 to 16 further comprising: one or several other transistors in a plane parallel to the principal plane of the substrate and passing through the gate (108) of the first transistor ($T_{11}$) and/or the gate (108) of the second transistor ($T_{21}$).

18. Microelectronic device according to any of claims 1 to 17 further comprising at least one contact pad between the gate of the first transistor and the gate of the second transistor.

19. Microelectronic device according to any of claims 1 to 18, wherein the transistors belong to a SRAM memory cell.

**Patentansprüche**

1. Mikroelektronische Vorrichtung, aufweisend:

> - ein Substrat (100), auf dem eine Übereinanderschichtung von Schichten angeordnet sind,
> - mindestens einen ersten Transistor ($T_{11}$), der sich auf einem gegebenen Niveau der Übereinanderschichtung befindet,
> - mindestens einen zweiten Transistor ($T_{21}$), der sich auf einem zweiten Niveau der Übereinanderschichtung oberhalb des gegebenen Niveaus befindet, wobei der erste Transistor ($T_{11}$) eine Gate-Elektrode (108) aufweist, die sich gegenüberliegend einer Kanalzone (116) des zweiten Transistors ($T_{21}$) befindet, wobei der erste Transistor und der zweite Transistor über eine isolierende Zone (220) getrennt sind,

wobei die isolierende Zone aus mehreren unterschiedlichen dielektrischen Materialien (221, 222) gebildet ist und in einem ersten Gebiet (R1), zwischen dem Gate des ersten Transistors und dem Kanal des zweiten Transistors, eine Zusammensetzung und eine Dicke (ec) hat, die so vorgesehen sind, dass eine erste elektrische Kapazität C1 zwischen der Gate-Elektrode des ersten Transistors und dem Kanal des zweiten Transistors gebildet wird, wobei die isolierende Zone ein zweites Gebiet (R2) aufweist, dessen dielektrische Eigenschaft und Dicke sich von denen des ersten Gebietes unterscheidet und das sich zwischen mindestens einer Zugangszone des ersten Transistors und mindestens einer Zugangszone des zweiten Transistors befindet, wobei die Zusammensetzung und die Dicke (ec) des zweiten Gebietes so vorgesehen sind, dass eine zweite elektrische Kapazität C2 zwischen der Zugangszone des ersten Transistors und der Zugangszone des zweiten Transistors gebildet wird, derart, dass C2 < C1.

2. Vorrichtung nach Anspruch 1, bei der die isolierende Zone im ersten Gebiet (R1) eine Zusammensetzung und eine Dicke (ec) hat, die so vorgesehen sind, dass eine Kopplung zwischen dem Gate des ersten Transistors ($T_{11}$) und dem Kanal des zweiten Transistors ($T_{21}$) ermöglicht wird.

3. Vorrichtung nach Anspruch 2, bei der die isolierende Zone (220) in dem zweiten Gebiet (R2) zwischen der Zugangszone des ersten Transistors ($T_{11}$) und der Zugangszone des zweiten Transistors ($T_{21}$) eine Zusammensetzung und eine Dicke hat, die so vorgesehen sind, dass eine Kopplung zwischen der Zugangszone des ersten Transistors und der Zugangszone des zweiten Transistors begrenzt oder verhindert wird.

4. Mikroelektronische Vorrichtung nach einem der Ansprüche 2 oder 3, bei der die Kopplung zwischen dem Gate des ersten Transistors und dem Kanal des zweiten Transistors derart ist, dass eine Änderung des Potentials des Gate des ersten Transistors ($T_{11}$) eine Änderung der Schwellenspannung des zweiten Transistors ($T_{21}$) zur Folge hat.

5. Mikroelektronische Vorrichtung nach einem der Ansprüche 2 bis 4, bei der Vdd eine Versorgungsspannung der Vorrichtung ist, die Kopplung zwischen dem Gate des ersten Transistors und dem Kanal des zweiten Transistors derart ist, dass eine Änderung des Potentials des Gate des ersten Transistors von 0 bis Vdd erlaubt, eine Änderung der Schwellenspannung des zweiten Transistors von mindestens 50 mV zu erzielen.

6. Mikroelektronische Vorrichtung nach Anspruch 5, bei der sich das Potential des Gate zwischen 0 und Vdd oder zwischen -Vdd und +Vdd ändert.

7. Mikroelektronische Vorrichtung nach einem der Ansprüche 1 bis 6, bei der das erste Gebiet (R1) aus einem ersten dielektrischen Material (221) gebildet ist, das eine erste dielektrische Konstante $k_1$ hat, und das zweite Gebiet (R2) aus einem zweiten dielektrischen Material (222) gebildet ist, das eine zweite dielektrische Konstante $k_2$ hat, derart, dass $k_2 < k_1$.

8. Mikroelektronische Vorrichtung nach einem der Ansprüche 1 bis 6, bei der das erste Gebiet (R1) aus einem ersten dielektrischen Material (221) gebildet ist, das eine erste dielektrische Konstante $k_1$ hat, wobei das zweite Gebiet (R2) eine Übereinanderschichtung des ersten dielektrischen Materials (221) und eines zweiten dielektrischen Materials (222) aufweist, das eine zweite dielektrische Konstante $k_2$

hat, derart, dass $k_2 < k_1$.

9. Mikroelektronische Vorrichtung nach einem der Ansprüche 1 bis 6, bei der das erste Gebiet (R1) aus einer ersten Übereinanderschichtung eines ersten dielektrischen Materials (221) und eines zweiten dielektrischen Materials (222) gebildet ist, wobei das zweite Gebiet (R2) eine zweite Übereinanderschichtung des ersten dielektrischen Materials (221) und des zweiten dielektrischen Materials (222) aufweist, wobei die jeweiligen Dicken des ersten dielektrischen Materials (221) und des zweiten dielektrischen Materials (222) in der ersten Übereinanderschichtung und der zweiten Übereinanderschichtung unterschiedlich sind.

10. Mikroelektronische Vorrichtung nach einem der Ansprüche 1 bis 9, bei der das erste Gebiet (R1) der isolierenden Zone (220) eine $SiO_2$-Äquivalenzdicke zwischen 1 und 50 Nanometer aufweist.

11. Mikroelektronische Vorrichtung nach einem der Ansprüche 1 bis 10, wobei die Vorrichtung weiter dotiert ist mit: Mitteln zum Modulieren der Schwellenspannung des zweiten Transistors, die Polarisierungsmittel aufweisen, die dazu bestimmt sind, ein veränderliches Potential an das Gate des ersten Transistors anzulegen und vorgesehen sind, um:

    - an das Gate des ersten Transistors, während einer ersten Phase, mindestens ein erstes Potential anzulegen,
    - an das Gate des ersten Transistors, während einer zweiten Phase, mindestens ein zweites Potential anzulegen, das von dem ersten Potential verschieden ist.

12. Mikroelektronische Vorrichtung nach Anspruch 11, bei der das erste Potential vorgesehen ist, um den zweiten Transistors durchlassend zu machen und dem zweiten Transistor eine erste Schwellenspannung zu erteilen, wobei das zweite Potential vorgesehen ist, um den zweiten Transistor sperrend zu machen und ihm eine zweite Schwellenspannung zu erteilen, die größer als die erste Schwellenspannung ist.

13. Mikroelektronische Vorrichtung nach einem der Ansprüche 1 bis 12, bei der sich die Kanalzone des ersten Transistors ($T_{11}$) vollständig gegenüberliegend des Gate des zweiten Transistors ($T_{21}$) befindet.

14. Mikroelektronische Vorrichtung nach einem der Ansprüche 1 bis 13, die weiter, auf einer Achse orthogonal zur Hauptebene des Substrates, die durch das Gate des ersten Transistors und/oder des zweiten Transistors hindurch verläuft, einen oder mehrere weitere Transistoren aufweist.

15. Mikroelektronische Vorrichtung nach einem der Ansprüche 1 bis 14, die weiter aufweist:

mindestens einen dritten Transistor ($T_{21}$), der sich auf dem Niveau des ersten Transistors in der Übereinanderschichtung befindet, und mindestens einen vierten Transistor ($T_{21}$), der sich oberhalb des dritten Transistors befindet, wobei der vierte Transistor ($T_{21}$) und der dritte Transistor über eine dielektrische Zone getrennt sind, die vorgesehen ist, um eine Kopplung zwischen dem dritten Transistor und dem vierten Transistor zu begrenzen oder zu verhindern.

16. Mikroelektronische Vorrichtung nach einem der Ansprüche 1 bis 15, die weiter aufweist:

mindestens einen dritten Transistor ($T_{21}$), der sich auf dem Niveau des ersten Transistors in der Übereinanderschichtung befindet, und mindestens einen vierten Transistor ($T_{21}$), wobei sich ein fünfter Transistor ($T_{21}$) zur Entkopplung zwischen dem dritten Transistor und dem vierten Transistor befindet.

17. Mikroelektronische Vorrichtung nach einem der Ansprüche 1 bis 16, die weiter aufweist:

einen oder mehrere weitere Transistoren in einer Ebene, die parallel zur Hauptebene des Substrates ist und durch das Gate (108) des ersten Transistors ($T_1$) und/oder das Gate (118) des zweiten Transistors ($T_{21}$) hindurch verläuft.

18. Mikroelektronische Vorrichtung nach einem der Ansprüche 1 bis 17, die weiter mindestens ein Kontaktstück zwischen dem Gate des ersten Transistors und dem Gate des zweiten Transistors aufweist.

19. Mikroelektronische Vorrichtung nach einem der Ansprüche 1 bis 18, bei der die Transistoren zu einer SRAM-Speicherzelle gehören.

FIG.1

FIG.2

FIG.3

FIG.4

EP 2 131 397 B1

FIG.5

FIG.6

FIG.7

20

FIG.8

FIG.9

FIG.10

FIG.11

FIG.12A

FIG.12B

FIG.13

FIG.14

FIG.15A

FIG.15B

FIG.15C

FIG.16

FIG.17

FIG.18

T$_{11}$

221

## FIG.19A

224

223

222

221

## FIG.19B

## FIG.20A

221

222

## FIG.20B

221

222

## FIG.20C

## RÉFÉRENCES CITÉES DANS LA DESCRIPTION

**Documents brevets cités dans la description**

- EP 1705693 A
- US 7115950 B
- US 5567959 A
- US 20060062061 A

**Littérature non-brevet citée dans la description**

- **Tetsu Ohtou.** Variable-Body-Factor SOI MOSFET With Ultrathin Buried Oxide for Adaptative Threshold Voltage and Leakage Control. *IEEE Transactions on Electron Devices,* Janvier 2008, vol. 55 (1
- **Lim ; Fossum.** *IEEE Transactions on electron devices,* Octobre 1983, vol. ED-30 (10